# FASCICULE DE BREVET EUROPEEN

(11) **EP 3 261 116 B1**
(45) Date de publication et mention de la délivrance du brevet: **02.10.2019**
(21) Numéro de dépôt: 17175943.4
(22) Date de dépôt: 14.06.2017
(51) Int. Cl.: H01L 21/56, H01L 23/31, H01L 25/03, H01L 21/683

(54) **PROCEDE DE FABRICATION COLLECTIVE DE MODULES ELECTRONIQUES 3D**
VERFAHREN ZUR GEMEINSAMEN HERSTELLUNG VON ELEKTRONISCHEN 3D-MODULEN
METHOD FOR THE COLLECTIVE PRODUCTION OF 3D ELECTRONIC MODULES

(30) Priorité: 22.06.2016 FR 1655798
(43) Date de publication de la demande: 27.12.2017
(73) Titulaire: 3D Plus, 78530 Buc (FR)
(72) Inventeur: VAL, Christian, 78470 SAINT REMY LES CHEVREUSE (FR)
(74) Mandataire: Henriot, Marie-Pierre

(56) Documents cités:
- US-A1- 2003 178 716
- US-A1- 2009 209 052

## Description

Le domaine de l'invention est celui de la fabrication collective de modules électroniques 3D à épaisseur réduite comportant un empilement d'au moins deux puces électroniques.

US2009/209052 décrit un procédé de fabrication collective de modules électroniques. Ce procédé comprend
A1) une étape de fabrication d'un lot de n tranches sur une même plaque, d'épaisseur es comprenant du silicium, recouverte sur une face de plots de test puis d'une couche isolante, formant le substrat isolant et munie d'au moins un composant électronique connecté aux plots de test à travers ladite couche isolante, les composants étant séparés les uns des autres par des premières rainures, les plots de connexion des composants étant connectés à des pistes qui affleurent au niveau des rainures;
B1) une étape de dépôt d'un support adhésif sur la face côté composants,
C1) une étape de retrait de la plaque de silicium de manière à faire apparaître les plots de test,
D1) une étape de test électrique des composants de la plaque par les plots de test, et de marquage des composants valides,
E1) une étape de report sur un film adhésif des tranches comportant chacune un composant valide, les tranches étant séparées par des deuxièmes rainures au niveau desquelles affleurent les pistes de connexion des composants valides. Cette étape répétée K fois, est suivie d'une étape d'empilement des K plaques, de formation, au niveau des deuxièmes rainures, de troisièmes rainures métallisées dans l'épaisseur de l'empilement et destinés à la connexion des tranches entre elles. *

L'arrivée sur le marché de composants fonctionnant à haute fréquence (mémoires, processeurs, ...) fait que l'utilisation de puces non encapsulées (puces nues) pose de nouveaux problèmes de rendement. Le test de puces nues sous pointes devient très délicat au-delà des fréquences d'environ 1 GHz. La conséquence première est qu'en cas d'empilage de ces composants dans un module électronique 3D, certaines puces pourront fonctionner à la fréquence maximale, d'autres non; il en résulte qu'un module comprenant une pluralité de puces ne pourra pas fonctionner à la fréquence maximale.

Un moyen de contourner cette difficulté est d'utiliser des puces encapsulées c'est-à-dire placées dans un boîtier qui lui, peut être complètement testé. En effet, un boîtier comprend des sorties sous forme de billes de brasure qui sont à des pas supérieurs à celui des plots des puces :
Pas des plots des puces : 50 à 100 µm,
Pas des boîtiers à billes encapsulant une puce: de 400 à 800 µm.

Des sockets de test peuvent donc être utilisés et les boîtiers sont ainsi testables à des fréquences éventuellement supérieures à 1 GHz, ainsi qu'à des températures de fonctionnement comprises entre -55°C et +125°C.

Mais un empilement de boîtiers est plus épais qu'un empilement de puces, et conduit donc à un module 3D également plus épais alors que l'on souhaite obtenir un module 3D à épaisseur réduite.

En partant de ce constat, il faut alors trouver une technologie d'empilage adaptée à ces boîtiers pouvant fonctionner à haute fréquence, et permettant d'obtenir des modules 3D à épaisseur réduite.

En conséquence, il demeure à ce jour un besoin pour un procédé de fabrication collective de modules électroniques 3D donnant simultanément satisfaction à l'ensemble des exigences précitées, en termes de fiabilité des puces électroniques à des fréquences de fonctionnement notamment supérieures à 1 GHz, à des températures de fonctionnement comprises entre -55°C et +125°C et d'épaisseur réduite des modules 3D obtenus.

Plus précisément l'invention a pour objet un procédé de fabrication collective de modules électroniques 3D, chaque module électronique 3D comprenant un empilement d'au moins deux boîtiers électroniques à billes, reportables en surface, testés à leur température et fréquence de fonctionnement, qui comprend :
- une étape de fabrication de plaques reconstituées, chaque plaque reconstituée étant fabriquée selon un premier mode de réalisation selon les sous-étapes suivantes dans l'ordre suivant :
   ∘ A1) les boîtiers électroniques sont posés sur une première peau collante côté billes,
   ∘ B1) moulage des boîtiers électroniques dans la résine et polymérisation de la résine, pour obtenir la plaque intermédiaire,
   ∘ C1) amincissement de la plaque intermédiaire sur la face de la plaque intermédiaire opposée aux billes,
   ∘ D1) retrait de la première peau collante et pose de la plaque intermédiaire sur une deuxième peau collante, côté opposé aux billes,
   ∘ E1) amincissement de la plaque intermédiaire sur la face côté billes, ou une étape de retrait des billes (4) desdits boîtiers électroniques, préalablement à l'étape A1,
   ∘ F1) formation d'une couche de redistribution côté billes,
   ∘ G1) retrait de la deuxième peau collante pour obtenir une plaque reconstituée d'épaisseur inférieure à l'épaisseur d'origine des boîtiers électroniques,
- plusieurs plaques reconstituées ayant été obtenues à l'issue des sous-étapes précédentes, empilement des plaques reconstituées,
- découpe des plaques reconstituées empilées pour obtenir des modules 3D.

L'invention a aussi pour objet un procédé de fabrication collective de modules électroniques 3D, chaque module électronique 3D comprenant un empilement d'au moins deux boîtiers électroniques à billes, reportables en surface, testés à leur température et fréquence de fonctionnement, qui comprend :
- une étape de fabrication de plaques reconstituées, chaque plaque reconstituée étant fabriquée selon un deuxième mode de réalisation selon les sous-étapes suivantes dans l'ordre suivant :
   ∘ A2) les boîtiers électroniques sont posés sur une première peau collante côté opposé aux billes,
   ∘ B2) moulage des boîtiers électroniques dans la résine et polymérisation de la résine, pour obtenir la plaque intermédiaire,
   ∘ C2) amincissement de la plaque intermédiaire sur la face de la plaque intermédiaire côté billes, ou une étape de retrait des billes (4) desdits boîtiers électroniques,
   ∘ D2) formation d'une couche de redistribution côté billes,
   ∘ E2) retrait de la première peau collante et pose de la plaque intermédiaire amincie sur une deuxième peau collante côté RDL,
   ∘ F2) amincissement de la plaque intermédiaire sur la face de la plaque intermédiaire opposée aux billes,
   ∘ G2) retrait de la deuxième peau collante pour obtenir une plaque reconstituée d'épaisseur inférieure à l'épaisseur d'origine des boîtiers électroniques,
- plusieurs plaques reconstituées ayant été obtenues à l'issue des sous-étapes précédentes, empilement des plaques reconstituées,
- découpe des plaques reconstituées empilées pour obtenir des modules 3D.

Il y a donc deux étapes d'amincissement.

Les boîtiers électroniques sont des boîtiers BGA ou des boîtiers flip-chips ; les boîtiers électroniques BGA peuvent comporter des protubérances centrales.

La fréquence de fonctionnement est notamment supérieure à 1 GHz, et/ou la température de fonctionnement est par exemple comprise entre - 55°C et 125 °C.

L'étape d'amincissement de la plaque intermédiaire sur la face de la plaque intermédiaire côté billes, peut être remplacée par une étape de retrait des billes desdits boîtiers électroniques préalablement à l'étape de pose des boîtiers électroniques sur la première peau collante.

D'autres caractéristiques et avantages de l'invention apparaîtront à la lecture de la description détaillée qui suit, faite à titre d'exemple non limitatif et en référence aux dessins annexés dans lesquels :
les figures 1 représentent schématiquement des exemples de boîtiers électroniques de type BGA avec sur-épaisseur (fig 1a), sans sur-épaisseur (fig 1b), de type Flip-Chip (fig 1c), vus en coupe,
les figures 2 illustrent différentes étapes d'un exemple de procédé selon l'invention,
les figures 3 illustrent différentes étapes d'un autre exemple de procédé selon l'invention,
la figure 4 représente schématiquement un exemple de plaque reconstituée obtenue par le procédé selon l'invention, vue en coupe,
la figure 5 représente schématiquement un exemple d'empilement de 4 plaques reconstituées obtenues par le procédé selon l'invention, vu en coupe.

D'une figure à l'autre, les mêmes éléments sont repérés par les mêmes références.

Dans la suite de la description, les expressions « supérieur », « inférieur », « avant », « arrière », «côté», sont utilisées en référence à l'orientation des figures décrites. Dans la mesure où le dispositif peut être positionné selon d'autres orientations, la terminologie directionnelle est indiquée à titre d'illustration et n'est pas limitative.

Le test électrique des puces nues ne peut garantir un fonctionnement fiable à des fréquences supérieures à 1 Ghz. En revanche, le test de boîtiers électroniques c'est-à-dire de composants électroniques à billes de connexion, reportables en surface et incluant des puces, peut s'appliquer à ces fréquences supérieures à 1 GHz et garantit également une température de fonctionnement comprise entre -55°C et +125°C.

L'invention est basée sur la fabrication d'une plaque reconstituée non pas avec des puces nues mais avec des boîtiers électroniques. Une fois que les plaques ont été reconstituées avec N boîtiers BGA «bons», (N pouvant atteindre plusieurs centaines), leur empilage, découpe etc. se fera par exemple comme déjà décrit dans les brevets FR 03 07977 et FR 06 07442.

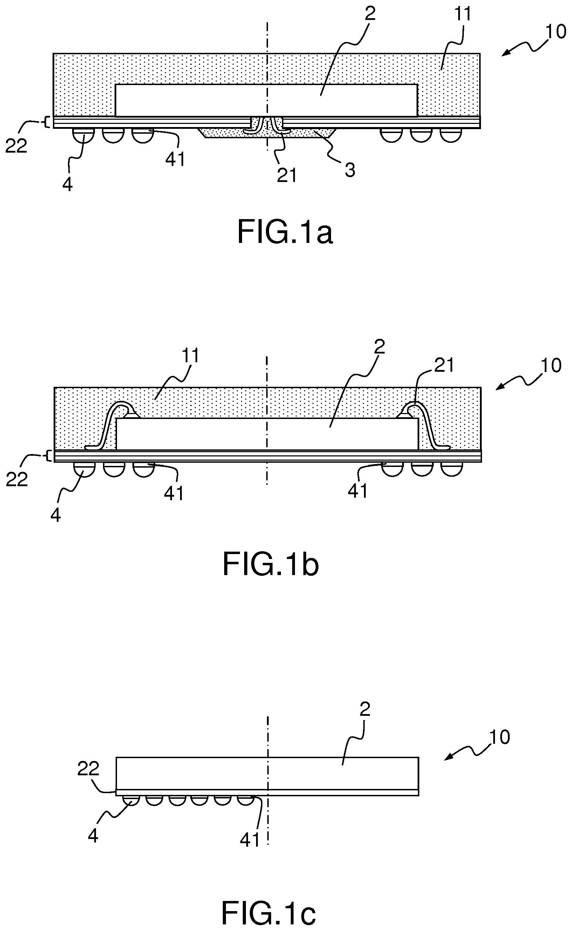

On désigne par boîtier électronique 10 dont des exemples sont montrés figure 1 :
- un boîtier à billes (BGA ou Ball Grid Array) 10 à billes de connexion 4 (ou billes de brasure), c'est-à-dire une puce nue 2 encapsulée dans de la résine 11, cette puce nue 2 présentant des fils de connexion 21 reliées à un circuit d'interconnexion 22 (généralement à plusieurs couches) muni desdites billes 4. Ces fils noyés dans la résine sont reliées à la face supérieure du circuit (fig 1b), ou ces fils sont reliés à la face inférieure au circuit et également protégés par de la résine, en formant une surépaisseur centrale 3 en saillie (ou protubérance centrale) sous le boîtier (fig 1a).
   Les billes 4 de connexion de ces boîtiers ont une épaisseur e_{b} typiquement comprise entre 200 µm et 400 µm ; la surépaisseur 3 au centre du boîtier, inhérente aux boîtiers mémoires, est typiquement d'environ 150 µm ; l'épaisseur e_{c} du corps du boîtier (c'est-à-dire le boîtier sans les billes de connexion) est typiquement comprise entre 0.8 mm et 0.9 mm ; l'épaisseur totale E d'un boîtier (E = e_{b} + e_{c}) étant donc comprise entre 0.82 mm et 1.3 mm.
- un composant flip-chip 10, c'est-à-dire une puce 2 non encapsulée reliée à une couche d'interconnexion 22 dite couche de redistribution, munie de billes de connexion 4 (fig 1c). Ce type de composant Flip-Chip est considéré selon l'invention comme un boîtier 10, car il :
   ∘ peut être reporté sur un substrat comme les boîtiers à billes (BGA),
   ∘ testé avant livraison au client, car le pas des billes (de 100 à 500 µm) est beaucoup plus élevé que celui des plots des puces (de 40 à 100 µm), et permet que le composant soit testé en utilisant des sockets de test et donc à des fréquences éventuellement supérieures à 1 GHz.
   Par ailleurs, il est plus facile de disposer de tels boîtiers Flip-Chip que de puces nues, et ils sont moins encombrants que des boîtiers BGA. Ces boîtiers Flip-Chip ne présentent pas de sur-épaisseur comme indiqué pour certains boîtiers BGA.
   Les billes 4 de connexion de ces boîtiers Flip-Chip ont une épaisseur e_{b} typiquement comprise entre 50 µm et 150 µm ; l'épaisseur e_{c} du corps du boîtier Flip-Chip (c'est-à-dire le boîtier sans les billes de connexion) est typiquement comprise entre 100 µm et 400 µm. L'épaisseur totale E d'un boîtier (E = e_{b} + e_{c}) étant donc comprise entre 150 µm et 550 µm.

Les plots 41 et le circuit ou la couche d'interconnexion 22 ne sont plus représentés sur les figures suivantes pour simplifier.

De tels boîtiers testés 10 sont commercialisés par différents fabricants parmi lesquels on peut citer : Xilinx, Micron, Samsung, ....

Selon l'invention, des modules électroniques 3D comprenant un empilement d'au moins deux boîtiers électroniques 10 à billes, reportables en surface, testés à leur température et fréquence de fonctionnement sont fabriqués collectivement de la manière suivante :
- fabrication de plusieurs plaques reconstituées, chaque plaque reconstituée 60 ne comportant que N «bons» boîtiers c'est-à-dire que des boîtiers testés,
- empilement des plaques reconstituées,
- découpe des plaques reconstituées empilées pour obtenir des modules 3D.

Le déroulement des étapes de fabrication d'une plaque reconstituée varie selon que les boîtiers électroniques sont posés sur une première peau collante, côté billes de connexion ou côté opposé. On retrouve les mêmes étapes mais réalisées dans un ordre différent.

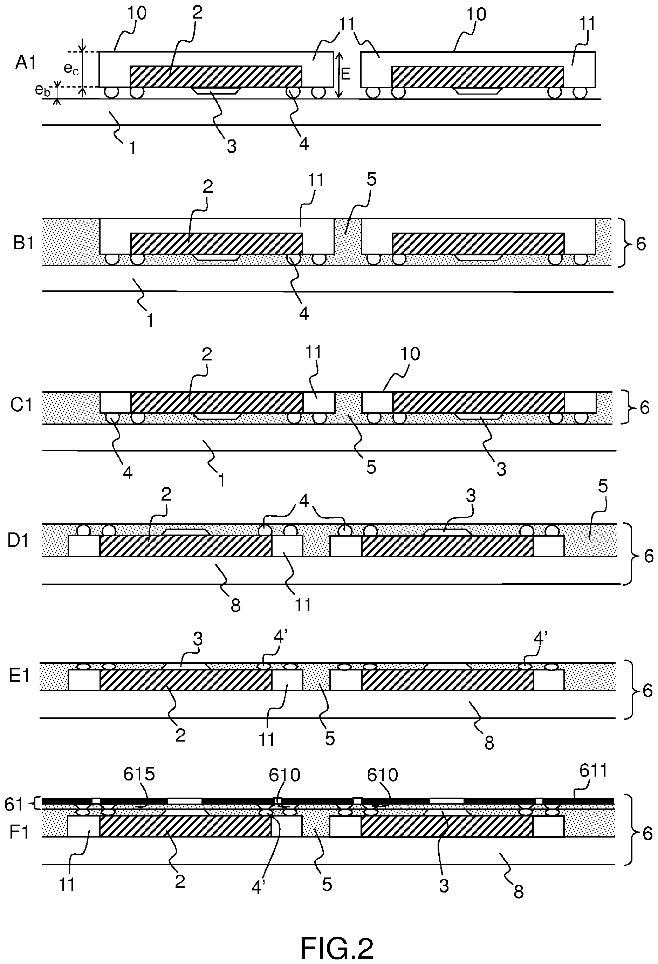

On décrit en relation avec la figure 2, le déroulement des étapes lorsque les boîtiers 10 sont posés côté billes de connexion.
- Etape A1 : Les N boîtiers 10 sont posés sur une première peau collante 1 encore appelée «tape» en anglais, du côté des billes de connexion 4 au moyen d'un équipement de Pick and Place. Mais il n'y a pas d'étape de brasage des billes de connexion ; les billes 4 se retrouvent simplement provisoirement fixées à cet adhésif 1. Ces N boîtiers sont tous les mêmes.
- Etape B1 : Moulage des boîtiers 10 dans de la résine 5 par exemple par compression ou par coulage. Puis polymérisation de la résine. On a alors obtenu une plaque intermédiaire 6.
- Etape C1 : Amincissement de cette plaque intermédiaire du côté de sa face arrière (= face opposée aux billes). L'amincissement des faces arrière des boîtiers 10 permet d'atteindre les faces arrière des puces 2 situées à l'intérieur des boîtiers 10 : l'amincissement peut être limité à l'apparition des faces arrière des puces 2 ou peut aller jusqu'à amincir les puces 2 elles-mêmes. L'épaisseur e_{c} du corps du boîtier 10 peut être réduite d'environ 30% à 35%.
- Etape D1 : retrait de la première peau collante 1 et pose de la plaque intermédiaire ainsi amincie sur une deuxième peau collante 8 côté opposé aux billes 4 de brasure des boîtiers (le côté aminci à l'étape C1 est collé à la peau collante 8).
- Etape E1 : un second amincissement est effectué afin de réduire l'épaisseur e_{b} des billes de brasure 4. Les billes sont par exemple composées de étain/argent/cuivre (Sn/Ag/Cu, encore nommé SAC). On obtient des billes amincies 4'.
- Etape F1 : Formation d'une couche de redistribution 61 (aussi désignée couche RDL, acronyme de l'expression anglo-saxonne ReDistribution Layer) côté billes amincies 4'. Cette couche RDL formée à partir d'une résine photogravable 615, comporte des contacts électriques 610 avec les billes 4' et une ou plusieurs sous-couches comportant des conducteurs électriques 611 reliant les contacts 610 jusqu'à la périphérie du boîtier (= jusqu'aux chemins de découpe 70). En effet lorsque l'empilement des plaques 60 sera effectué, des conducteurs verticaux (selon la direction de l'empilement) reliés aux sections des conducteurs 611 présentes sur la périphérie, seront réalisés sur des faces verticales des modules 3D. Cette couche RDL 61 est effectuée par les dépôts classiques : diélectrique photogravable et dépôts métalliques en utilisant une barrière de diffusion du type Titane/Tungstène puis du cuivre.
- Etape G1 : Retrait de la deuxième peau collante 8 pour obtenir une plaque reconstituée 60.

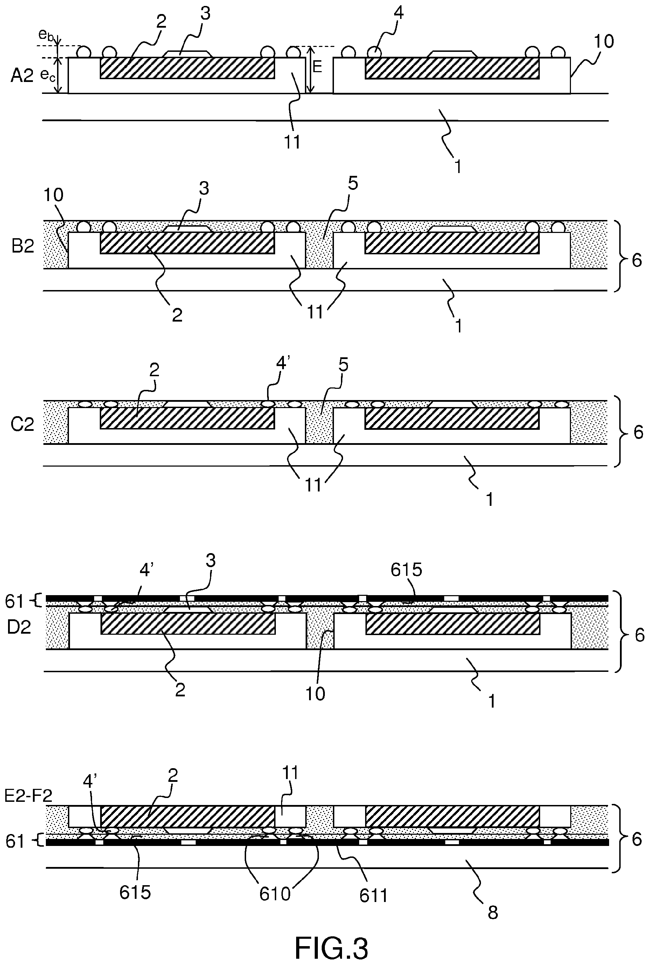

On décrit à présent en relation avec la figure 3 le déroulement des étapes lorsque les boîtiers 10 sont posés côté opposé aux billes 4 de connexion.
- Etape A2 : Les boîtiers 10 sont collés sur une première peau collante 1 du côté ne portant pas les billes 4. La tête de l'équipement de Pick and Place utilisé doit être adaptée à la saisie de boîtiers n'ayant pas une surface plane continue comme dans le cas précédent. La tête aspirante de cet équipement est évidée pour éviter les billes 4 et l'éventuelle sur-épaisseur centrale 3 des boîtiers 10.
- Etape B2 : Moulage des boîtiers dans de la résine 5 par exemple par compression ou coulage, jusqu'au plan des billes 4 ou légèrement au-dessus du plan des billes. Les boîtiers 10 étant reportés sur la première peau collante côté opposé aux billes, il n'y a pas de problème comme éventuellement dans l'étape B1 de la figure 2 avec le remplissage de la résine dans l'espace entre la surface des billes et la première peau collante. Puis polymérisation de la résine. On a obtenu la plaque intermédiaire 6.
- Etape C2 : Amincissement de la plaque intermédiaire 6 appliqué à la face comportant les billes 4, pour réduire le volume des billes et surtout leur épaisseur. On obtient des billes amincies 4'.
- Etape D2 : L'interconnexion des billes amincies 4' avec les futurs conducteurs verticaux est effectuée comme dans l'étape F1 par une couche de redistribution 61 (RDL) qui comporte des contacts électriques 610 avec les billes 4' et une ou deux sous-couches de redistribution.
- Etape E2 : La plaque intermédiaire 6 amincie et complétée de la couche RDL, est décollée de la première peau collante 1, puis retournée et collée sur une deuxième peau collante 8 côté couche RDL.
- Etape F2 : Un amincissement est alors effectué sur face opposée à la couche RDL, comme indiqué à l'étape C1.
- Etape G2 : Retrait de la deuxième peau collante 8 pour obtenir une plaque reconstituée 60.

A l'issue de ces étapes on a donc obtenu une plaque reconstituée de faible épaisseur, ne comportant que de «bons» boîtiers (N boîtiers) c'est-à-dire que des boîtiers testés, et destinée à être empilée sur d'autres plaques reconstituées de la même manière.

Les deux manières de dérouler les étapes de fabrication d'une plaque reconstituée 60 telles que décrites précédemment peuvent être utilisées pour un boîtier 10 BGA avec ou sans sur-épaisseur centrale 3 ou un boîtier 10 de type Flip-chip. Dans le cas d'un boîtier BGA sans sur-épaisseur 3 ou un boîtier de type Flip-chip, l'étape d'amincissement des faces du côté des billes n'est pas limitée par la protubérance centrale (étapes E1 ou C2) et l'amincissement peut s'approcher jusqu'à environ 50 µm de la surface du corps du boîtier. Cela permet dans le cas d'un boîtier BGA sans sur-épaisseur ou d'un boîtier de type Flip-chip de réduire un peu plus l'épaisseur totale du boîtier final d'environ 100 µm de plus.

Avant le report des boîtiers 10 sur la peau collante 1 des étapes A1 ou A2, il est possible de dé-biller (=retirer les billes 4) les boîtiers testés 10 qui sont sans protubérances centrales 3. Ce débillage est effectué collectivement après l'acquisition des boîtiers testés ; il est effectué mécaniquement par exemple ou par attaque chimique en phase gazeuse par plasma. Dans ces conditions, la surface du boîtier qui portait les billes ne comporte que les plots 41 (visibles sur la figure 1) avec ou sans un résidu de billes 4. L'étape E1 ou C2 d'amincissement des billes devient superflue. La RDL 61 est réalisée pour connecter non pas les billes 4' mais directement les plots 41 comme pour les étapes déjà décrites : étape F1 ou D2. L'avantage de cette approche est notamment une épaisseur du boîtier (corps + billes) un peu plus faible.

On récapitule dans le tableau ci-dessous les épaisseurs obtenues au fil de ces étapes pour un boîtier 10 BGA ou Flip-Chip.

| | Boîtier 10 BGA | Boîtier 10 Flip-Chip |
|---|---|---|
| Pas des billes 4 | 400 à 800 µm | 100 à 400 µm |
| Epaisseur des billes 4 avant amincissement | 200 à 400 µm | 50 à 150 µm |
| Epaisseur des billes 4' après amincissement pour un boîtier 10 avec sur-épaisseur centrale 3 | 150 à 200 µm | |
| Epaisseur des billes 4' après amincissement pour un boîtier 10 sans sur-épaisseur centrale 3 | 50 à 100 µm | 25 à 75 µm |
| Epaisseur des billes 4 après débillage | 0 à 10 µm | 0 à 10 µm |
| Epaisseur du corps du boîtier 10 avant amincissement | 800 à 900 µm | 100 à 400 µm |
| Epaisseur du corps du boîtier 10 après amincissement | 520 à 630 µm | 65 à 280 µm |
| Epaisseur totale du boîtier 10 avant amincissements (= à l'achat) | 1 à 1,3 mm | 150 à 650 µm |
| Epaisseur totale du boîtier 10 après amincissements | 670 à 830 µm | 90 à 355 µm |

Les épaisseurs indiquées pour les billes 4 ou 4' incluent celle des plots 41.

L'épaisseur de la plaque reconstituée 60 (=épaisseur des boîtiers et de la RDL) est donc comprise :
- entre 700 µm et 860 µm pour une plaque 60 avec boîtiers 10 BGA,
- entre 95 µm et 360 µm pour une plaque 60 avec boîtiers 10 Flip-Chip.

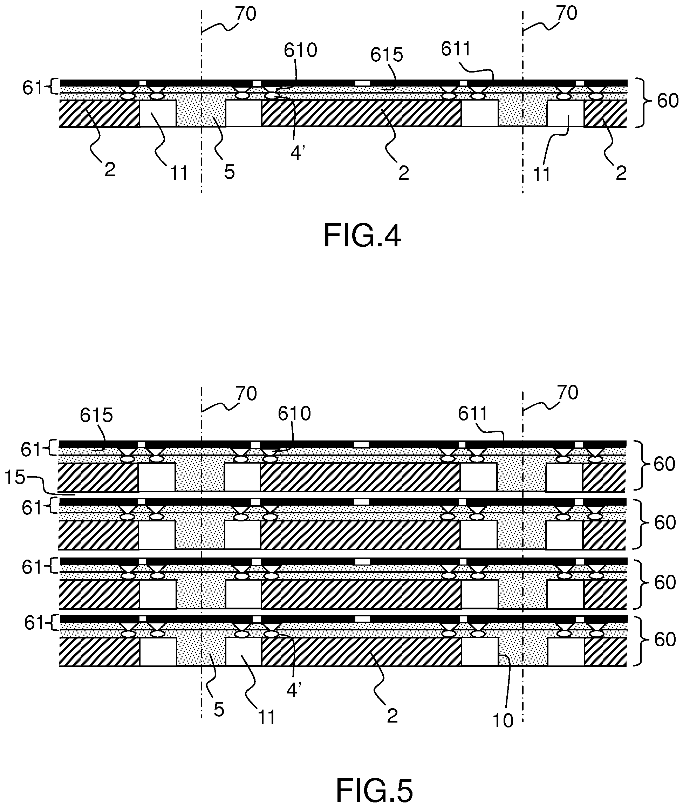

On montre figure 4 une plaque reconstituée 60 obtenue par l'un ou l'autre procédé et sur laquelle sont indiqués des chemins de découpe 70. Ces plaques reconstituées 60 sont alors empilées les unes sur les autres en alignant les chemins de découpe 70, et collées au moyen d'une colle 15 comme on peut le voir figure 5. Puis l'empilement est découpé selon les chemins de découpe pour obtenir N modules électroniques 3D qui seront complétés notamment par des bus verticaux formés sur des faces verticales des modules 3D.

## Revendications

1. Procédé de fabrication collective de modules électroniques 3D, chaque module électronique 3D comprenant un empilement d'au moins deux boîtiers électroniques (10) à billes, reportables en surface, testés à leur température et fréquence de fonctionnement, qui comprend :
- une étape de fabrication de plaques reconstituées, chaque plaque reconstituée (60) étant fabriquée selon les sous-étapes suivantes dans l'ordre suivant :
∘ A1) les boîtiers électroniques (10) sont posés sur une première peau collante (1) côté billes (4),
∘ B1) moulage des boîtiers électroniques (10) dans la résine (5) et polymérisation de la résine, pour obtenir la plaque intermédiaire (6),
∘ C1) amincissement de la plaque intermédiaire (6) sur la face de la plaque intermédiaire opposée aux billes,
∘ D1) retrait de la première peau collante (1) et pose de la plaque intermédiaire sur une deuxième peau collante (8), côté opposé aux billes (4),
∘ E1) amincissement de la plaque intermédiaire sur la face côté billes, ou une étape de retrait des billes (4) desdits boîtiers électroniques préalablement à l'étape de pose des boîtiers électroniques sur la première peau collante,
∘ F1) formation d'une couche de redistribution (61) côté billes,
∘ G1) retrait de la deuxième peau collante (8) pour obtenir une plaque reconstituée (6) d'épaisseur inférieure à l'épaisseur d'origine des boîtiers électroniques,
- plusieurs plaques reconstituées ayant été obtenues à l'issue des sous-étapes précédentes, empilement des plaques reconstituées,
- découpe des plaques reconstituées empilées pour obtenir des modules 3D.

2. Procédé de fabrication collective de modules électroniques 3D, chaque module électronique 3D comprenant un empilement d'au moins deux boîtiers électroniques (10) à billes, reportables en surface, testés à leur température et fréquence de fonctionnement, qui comprend :
- une étape de fabrication de plaques reconstituées, chaque plaque reconstituée (60) étant fabriquée selon les sous-étapes suivantes dans l'ordre suivant :
∘ A2) les boîtiers électroniques (10) sont posés sur une première peau collante (1) côté opposé aux billes,
∘ B2) moulage des boîtiers électroniques (10) dans la résine (5) et polymérisation de la résine, pour obtenir la plaque intermédiaire (6),
∘ C2) amincissement de la plaque intermédiaire (6) sur la face de la plaque intermédiaire côté billes, ou une étape de retrait des billes (4) desdits boîtiers électroniques préalablement à l'étape de pose des boîtiers électroniques sur la première peau collante,
∘ D2) formation d'une couche de redistribution (61) côté billes,
∘ E2) retrait de la première peau collante (1) et pose de la plaque intermédiaire amincie sur une deuxième peau collante (8) côté RDL,
∘ F2) amincissement de la plaque intermédiaire sur la face de la plaque intermédiaire opposée aux billes,
∘ G2) retrait de la deuxième peau collante (8) pour obtenir une plaque reconstituée (60) d'épaisseur inférieure à l'épaisseur d'origine des boîtiers électroniques,
- plusieurs plaques reconstituées ayant été obtenues à l'issue des sous-étapes précédentes, empilement des plaques reconstituées,
- découpe des plaques reconstituées empilées pour obtenir des modules 3D.

3. Procédé de fabrication collective de modules électroniques 3D selon l'une des revendications précédentes, **caractérisé en ce que** les boîtiers électroniques (10) sont des boîtiers BGA ou des boîtiers flip-chips.

4. Procédé de fabrication collective de modules électroniques 3D selon l'une des revendications précédentes, **caractérisé en ce que** la fréquence de fonctionnement est supérieure à 1 GHz.

5. Procédé de fabrication collective de modules électroniques 3D selon l'une des revendications précédentes, **caractérisé en ce que** la température de fonctionnement est comprise entre - 55°C et 125 °C.

6. Procédé de fabrication collective de modules électroniques 3D selon l'une des revendications précédentes, **caractérisé en ce que** des boîtiers électroniques (10) comportent des protubérances centrales (3).

## Patentansprüche

1. Verfahren zur kollektiven Fertigung von elektronischen 3D-Modulen, wobei jedes elektronische 3D-Modul einen Stapel von mindestens zwei elektronischen Gehäusen (10) mit Kugeln beinhaltet, welche an einer Oberfläche versetzbar sind, welche bei ihrer Betriebstemperatur und -frequenz getestet werden, welches folgende Schritte beinhaltet:
- einen Schritt der Fertigung von rekonstituierten Platten, wobei jede rekonstituierte Platte (60) in den folgenden Unterschritten in folgender Reihenfolge gefertigt wird:
∘ A1) die elektronischen Gehäuse (10) werden kugelseitig (4) auf einer ersten haftenden Haut (1) abgelegt,
∘ B1) Abformen der elektronischen Gehäuse (10) in dem Harz (5) und Polymerisieren des Harzes zum Erzielen der Zwischenplatte (6),
∘ C1) Verschmälern der Zwischenplatte (6) an der den Kugeln abgewandten Seite der Zwischenplatte,
∘ D1) Entfernen der ersten haftenden Haut (1) und Ablegen der Zwischenplatte mit der den Kugeln (4) abgewandten Seite auf einer zweiten haftenden Haut (8),
∘ E1) Verschmälern der Zwischenplatte an der Kugelseite, oder einen Schritt des Entfernens der Kugeln (4) von den elektronischen Gehäusen vor dem Schritt des Ablegens der elektronischen Gehäuse auf der ersten haftenden Haut,
∘ F1) Bilden einer kugelseitigen Umverteilungsschicht (61),
∘ G1) Entfernen der zweiten haftenden Haut (8) zum Erzielen einer rekonstituierten Platte (6) mit einer Dicke, welche geringer ist als die Ursprungsdicke der elektronischen Gehäuse,
- nachdem mehrere rekonstituierte Platten nach Beendigung der vorherigen Unterschritte erzielt wurden, Stapeln der rekonstituierten Platten,
- Zuschneiden der gestapelten rekonstituierten Platten zum Erzielen der 3D-Module.

2. Verfahren zur kollektiven Fertigung von elektronischen 3D-Modulen, wobei jedes elektronische 3D-Modul einen Stapel von mindestens zwei elektronischen Gehäusen (10) mit Kugeln beinhaltet, welche an einer Oberfläche versetzbar sind, welche bei ihrer Betriebstemperatur und -frequenz getestet werden, welches folgende Schritte beinhaltet:
- einen Schritt der Fertigung von rekonstituierten Platten, wobei jede rekonstituierte Platte (60) in den folgenden Unterschritten in folgender Reihenfolge gefertigt wird:
∘ A2) die elektronischen Gehäuse (10) werden mit der den Kugeln abgewandten Seite auf einer ersten haftenden Haut (1) abgelegt,
∘ B2) Abformen der elektronischen Gehäuse (10) in dem Harz (5) und Polymerisieren des Harzes zum Erzielen der Zwischenplatte (6),
∘ C2) Verschmälern der Zwischenplatte (6) an der Kugelseite der Zwischenplatte, oder einen Schritt des Entfernens der Kugeln (4) von den elektronischen Gehäusen vor dem Schritt des Ablegens der elektronischen Gehäuse auf der ersten haftenden Haut,
∘ D2) Bilden einer kugelseitigen Umverteilungsschicht (61),
∘ E2) Entfernen der ersten haftenden Haut (1) und RDL-seitiges Ablegen der verschmälerten Zwischenplatte auf einer zweiten haftenden Haut (8),
∘ F2) Verschmälern der Zwischenplatte an der den Kugeln abgewandten Seite der Zwischenplatte,
∘ G2) Entfernen der zweiten haftenden Haut (8) zum Erzielen einer rekonstituierten Platte (60) mit einer Dicke, welche geringer ist als die Ursprungsdicke der elektronischen Gehäuse,
- nachdem mehrere rekonstituierte Platten nach Beendigung der vorherigen unter Schritte erzielt wurden, Stapeln der rekonstituierten Platten,
- Zuschneiden der gestapelten rekonstituierten Platten zum Erzielen der 3D-Module.

3. Verfahren zur kollektiven Fertigung von elektronischen 3D-Modulen nach einem der vorhergehenden Ansprüche, **dadurch gekennzeichnet, dass** die elektronischen Gehäuse (10) BGA-Gehäuse oder Flip-chip-Gehäuse sind.

4. Verfahren zur kollektiven Fertigung von elektronischen 3D-Modulen nach einem der vorhergehenden Ansprüche, **dadurch gekennzeichnet, dass** die Betriebsfrequenz über 1 GHz beträgt.

5. Verfahren zur kollektiven Fertigung von elektronischen 3D-Modulen nach einem der vorhergehenden Ansprüche, **dadurch gekennzeichnet, dass** die Betriebstemperatur zwischen -55°C und 125 °C beträgt.

6. Verfahren zur kollektiven Fertigung von elektronischen 3D-Modulen nach einem der vorhergehenden Ansprüche, **dadurch gekennzeichnet, dass** die elektronischen Gehäuse (10) mittlere Vorsprünge (3) beinhalten.

## Claims

1. Method of collective fabrication of 3D electronic modules, each 3D electronic module comprising a stack of at least two, surface transferable, ball grid electronic packages (10), tested at their operating temperature and frequency, which comprises:
- a step of fabricating reconstituted wafers, each reconstituted wafer (60) being fabricated according to the following sub-steps in the following order:
∘ A1) the electronic packages (10) are placed on a first sticky skin (1), balls (4) side,
∘ B1) moulding of the electronic packages (10) in the resin (5) and polymerization of the resin, to obtain the intermediate wafer (6),
∘ C1) thinning of the intermediate wafer (6) on the face of the intermediate wafer opposite to the balls,
∘ D1) removal of the first sticky skin (1) and placing of the intermediate wafer on a second sticky skin (8), side opposite to the balls (4),
∘ E1) thinning of the intermediate wafer on the balls side face, or a step of removing the balls (4) of said electronic packages prior to the step of placing the electronic packages on the first sticky skin,
∘ F1) formation of a balls side redistribution layer (61),
∘ G1) removal of the second sticky skin (8) to obtain a reconstituted wafer (6) of smaller thickness than the original thickness of the electronic packages,
- several reconstituted wafers having been obtained on completion of the previous sub-steps, stacking of the reconstituted wafers,
- dicing of the stacked reconstituted wafers to obtain 3D modules.

2. Method of collective fabrication of 3D electronic modules, each 3D electronic module comprising a stack of at least two, surface transferable, ball grid electronic packages (10), tested at their operating temperature and frequency, which comprises:
- a step of fabricating reconstituted wafers, each reconstituted wafer (60) being fabricated according to the following sub-steps in the following order:
∘ A2) the electronic packages (10) are placed on a first sticky skin (1), side opposite to the balls,
∘ B2) moulding of the electronic packages (10) in the resin (5) and polymerization of the resin, to obtain the intermediate wafer (6),
∘ C2) thinning of the intermediate wafer (6) on the face of the intermediate wafer, balls side, or a step of removing the balls (4) of said electronic packages prior to the step of placing the electronic packages on the first sticky skin,
∘ D2) formation of a balls side redistribution layer (61),
∘ E2) removal of the first sticky skin (1) and placing of the thinned intermediate wafer on a second sticky skin (8), RDL side,
∘ F2) thinning of the intermediate wafer on the face of the intermediate wafer opposite to the balls,
∘ G2) removal of the second sticky skin (8) to obtain a reconstituted wafer (60) of smaller thickness than the original thickness of the electronic packages,
- several reconstituted wafers having been obtained on completion of the previous sub-steps, stacking of the reconstituted wafers,
- dicing of the stacked reconstituted wafers to obtain 3D modules.

3. Method of collective fabrication of 3D electronic modules according to one of the preceding claims, **characterized in that** the electronic packages (10) are BGA packages or flip-chip packages.

4. Method of collective fabrication of 3D electronic modules according to one of the preceding claims, **characterized in that** the operating frequency is greater than 1 GHz.

5. Method of collective fabrication of 3D electronic modules according to one of the preceding claims, **characterized in that** the operating temperature lies between -55°C and 125°C.

6. Method of collective fabrication of 3D electronic modules according to one of the preceding claims, **characterized in that** electronic packages (10) comprise central projections (3).
